# EUROPEAN PATENT APPLICATION

(11) **EP 2 341 114 A1**
(43) Date of publication of application: **06.07.2011**
(21) Application number: 09821969.4
(22) Date of filing: 15.10.2009
(51) Int. Cl.: C09J 7/02, B32B 27/00, H01L 21/304

(54) **PRESSURE-SENSITIVE ADHESIVE SHEET WITH SPONTANEOUSLY ROLLING PROPERTY**

(30) Priority: 21.10.2008 JP 2008271449
(71) Applicant: Nitto Denko Corporation, Ibaraki-shi Osaka 567-8680 (JP)
(72) Inventor: KIUCHI; Kazuyuki, Ibaraki-shi Osaka 567-8680 (JP); NISHIO, Akinori, Ibaraki-shi Osaka 567-8680 (JP)
(74) Representative: Grünecker, Kinkeldey, Stockmair & Schwanhäusser Anwaltssozietät
(86) International application number: PCT/JP2009/067869
(87) International publication number: WO 2010/047272

(57) **Abstract**

The pressure-sensitive adhesive sheet with spontaneously rolling property of the invention is a pressure-sensitive adhesive sheet comprising a contractible film layer, an elastic layer, a rigid film layer, an intermediate layer, and a pressure-sensitive adhesive layer satisfying the following requirements and laminated in this order, which is capable of undergoing spontaneous rolling from one end part in one direction or from opposing two end parts toward a center to form one or two cylindrical rolls when a stimulus causing a contraction is applied:
the elastic layer having a thickness of from 15 to 150 µm and a shear modulus at 80°C of from 1×10⁴ Pa to 5×10⁶ Pa,
the intermediate layer having a shear modulus at 23°C of from 1×10⁴ Pa to 4×10⁷ Pa, and
the pressure-sensitive adhesive layer having a pressure-sensitive adhesive strength of the pressure-sensitive adhesive layer or the pressure-sensitive adhesive layer after an adhesion reducing treatment (180° peeling, vs. silicon mirror wafer, tensile rate: 300 mm/minute) of 6.5 N/10 mm or less.

## Description

### Technical Field

The present invention relates to a pressure-sensitive adhesive sheet with spontaneously rolling property, which is capable of undergoing spontaneous rolling from an end part in the main contraction axis direction by heat or the like to form a cylindrical roll. The pressure-sensitive adhesive sheet with spontaneously rolling property is, for example, useful as pressure-sensitive adhesive sheets for re-peeling, such as a pressure-sensitive adhesive sheet for wafer temporary fixing, a pressure-sensitive adhesive sheet for wafer protection, and the like to be used in a processing step of semiconductor silicon wafers and the like.

### Background Art

Recently, demands for thinning and weight saving on materials for semiconductors have been further increased. With regard to silicon wafers for semiconductors, there has arisen necessity of thinning it to a thickness of 100 µm or less but such a thin wafer is very fragile and tends to be cracked. Thus, at wafer processing, there is adopted a method of holding a wafer on a pressure-sensitive adhesive sheet for temporary fixing, subjecting it to predetermined processing, and subsequently peeling and collecting the wafer.

Such a pressure-sensitive adhesive sheet for temporary fixing is generally composed of an active energy ray-curable pressure-sensitive adhesive layer and is, for example, utilized in a method of sticking the sheet on a wafer, subjecting the temporarily fixed wafer to processing such as grinding or dicing, subsequently curing the pressure-sensitive adhesive layer by irradiation with an active ray, and peeling the pressure-sensitive adhesive layer having a decreased pressure-sensitive adhesive strength from the wafer. However, the pressure-sensitive adhesive sheet having pressure-sensitive adhesive strength decreased by the irradiation with an active ray is still tightly adhered to the wafer surface by atmospheric pressure. Therefore, in order to peel the pressure-sensitive adhesive sheet from the wafer, it is necessary to perform operations such as striping-off of the pressure-sensitive adhesive sheet but there are problems that a rim of the wafer is liable to be chipped or broken owing to a stress on this occasion. Furthermore, when the thickness of the wafer is decreased after grinding (for example, when it is decreased to about 25 µm), the edge of the pressure-sensitive adhesive sheet stuck on the wafer may protrude from the wafer edge to the outside in some cases and there arises a concern that the protruded part adheres to members mounted on the ground surface side of the wafer, such as a working seat surface and a dicing tape, to cause a peeling difficulty.

Japanese Patent No. 3073239 discloses a pressure-sensitive adhesive sheet containing an active energy ray-curable pressure-sensitive adhesive layer and a heat contractible film in the layer constitution thereof. According to this pressure-sensitive adhesive sheet, since the heat contractible film is contracted upon irradiation with an active energy ray, elongation and wrinkling of the sheet generated by ultraviolet irradiation or the like can be prevented. However, peelability of the pressure-sensitive adhesive sheet from the wafer is still insufficient.

JP-A-2000-129227 discloses a pressure-sensitive adhesive sheet for temporary fixing of semiconductor wafers which comprises a contractible film, a rigid film, and an active energy ray-curable pressure-sensitive adhesive layer. According to this pressure-sensitive adhesive sheet, when the adhesive strength of the pressure-sensitive adhesive layer is decreased by irradiation with an active energy ray and also the contractible film is contracted by a necessary method, the pressure-sensitive adhesive sheet is deformed to reduce the contact area between the wafer and the pressure-sensitive adhesive layer, so that the pressure-sensitive adhesive sheet can be easily peeled from the wafer. However, when the present inventors have investigated similar ones with selecting arbitrary materials, since the pressure-sensitive adhesive sheet after heating is irregularly deformed, for example, the sheet is folded on the wafer surface resulting from occurrence of the contraction of the contractible film in a plurality of directions and the like, it has been found that peeling difficulty and adherend destruction may occur. In general, even when the sheet is one commercially available as a uniaxially contractible film, it is considered that secondary contraction(s) (one or two or more contractions having relatively weak contraction force) occur in axis direction(s) different from the main contraction axis direction by the action of a residual stress at production or attributable to a stress and a heat strain and the like imparted to the pressure-sensitive adhesive sheet during the production process and thus these contractions are combined to result in complex contraction.

In the case where the area of the adherend is small, the deformation of the pressure-sensitive adhesive sheet caused by the action of the secondary contraction(s) as mentioned above is small, so that problems at peeling tend to be little. However, as the adherend becomes large, the secondary contraction(s) increase and finally, the contraction in the main contraction axis direction is inhibited in some cases. Particularly, in the case of the pressure-sensitive adhesive sheet having a size widely utilized as a wafer, since the contraction inhibition in the main contraction axis direction as mentioned above is liable to occur, there may occur such incomplete peeling that a part of the pressure-sensitive adhesive sheet remains on the wafer after peeling or a problem that the adherend is damaged, or a cured pressure-sensitive adhesive is dropped from the pressure-sensitive adhesive sheet to stain the wafer by the action of an inhomogeneous stress at contraction.

Moreover, a wafer ground to very thin has a problem of occurrence of warpage. Recently, semiconductor wafers have been grown in size to 8 inches and 12 inches and further, as a result of required thinning in the IC card uses and the like, warpage is liable to occur on the semiconductor wafers after grinding and it becomes a large problem to eliminate the warpage. Particularly, in ultrathin chips such as IC cards and stacked integrated circuits, thinness, e.g., a final wafer thickness of less than 100 µm, is required, so that the warpage also increases. For example, in the case where an 8-inch wafer is ground to about 50 µm, although it depends on the kind of the pressure-sensitive adhesive sheet for temporary fixing and the kind of the wafer, the warpage reaches about 5 cm in the case where a large warpage is exhibited. There are a concern that the wafer fixed on a chuck table is lifted up by the warpage generated on such an ultrathin wafer and the wafer edge comes into contact with a grinding whetstone to damage the wafer, a concern that a stress is locally converged in the case of the deflected wafer at the time when the wafer is transferred with an adsorption pad and hence the wafer is damaged by adsorption impact, and also a concern that the conveyance of the wafer is obstructed since the wafer cannot be conveyed by a conventional conveying method and cannot be stored in dedicated storing cases commonly used. Furthermore, the thinly ground wafer has a low strength and is easily cracked by a small impact even when its warpage is small.

It has been found that the warpage of the wafer after grinding is greatly affected by the warpage of the wafer itself but is more greatly caused by a residual stress of the pressure-sensitive adhesive sheet for temporary fixing. Particularly, strain in the pressure-sensitive adhesive sheet for temporary fixing by a tensile stress and a pushing pressure at the time of sticking becomes a cause of generating a large warpage after the wafer has been thinned. Therefore, in order to reduce the residual stress, there is required not only a method of sticking the pressure-sensitive adhesive sheet for temporary fixing but also a constitution so that the residual stress is not generated in the pressure-sensitive adhesive sheet for temporary fixing itself.

### Background Art Documents

### Patent Documents

Patent Document 1: Japanese Patent No. 3073239
Patent Document 2: JP-A-2000-129227
Patent Document 3: JP-A-2000-212524

### Summary of the Invention

### Problems that the Invention is to Solve

An object of the invention is to provide a pressure-sensitive adhesive sheet capable of suppressing warpage of an adherend which may be generated upon grinding of the adherend and capable of being easy peeled from the adherend after grinding without generating damage, staining, and the like of the adherend.

### Means for Solving the Problems

The present inventors have considered that a pressure-sensitive adhesive sheet to which an easily peelable function is imparted is necessary for easily peeling the sheet from an adherend without causing damage, staining, and the like of the adherend. At the time when a work of peeling the pressure-sensitive adhesive sheet from the adherend is performed by hand, in order to make a peeling-start firstly, the tape is picked up at an end part of the adherend and then the tape is stretched and peeled off. However, in the case of a fragile adherend, the peeling-start is usually made by rubbing the tape without picking up the tape, that is, by enlarging the peeling angle as far as possible with minimizing a peeling stress so as not to break the adherend. Successively, by peeling off the tape so as to maintain the large peeling angle as far as possible, it is possible to peel the pressure-sensitive adhesive sheet from the fragile adherend.

Accordingly, the inventors have considered that, at the time of imparting the easy peelability by a stimulus such as heat, a pressure-sensitive adhesive sheet satisfying the object can be obtained if the sheet can be deformed as if a carpet were rolled up, as a form at tape peeling (hereinafter, the thus deformed one is referred to as "cylindrical roll"). The reason is that the peeling with causing such deformation means that a peeling angle at peeling is kept as large as possible and the peeling stress against the adherend is decreased as far as possible. Namely, it means that a possibility of damaging the fragile adherend can be minimized. Furthermore, since a little peeling stress leads to a decreased possibility of peeling off the pressure-sensitive adhesive onto the adherend, a possibility of staining the adherend by peeling can be also decreased. Moreover, even if the sheet adheres on a member at the wafer grinding surface side, the peeling stress can be also minimized and hence a risk of damaging the wafer decreases.

Therefore, they have investigated a material for realizing the formation of the cylindrical roll by a stimulus such as heat. As a result, they have found that a pressure-sensitive adhesive sheet obtained by laminating, on a contractible film layer contracting in at least one axis direction by a stimulus such as heat, an elastic layer and a rigid film layer each having predetermined physical properties as a restriction layer restricting the contraction of the contractible film layer and further laminating a pressure-sensitive adhesive layer forms one or two cylindrical rolls through spontaneous rolling from one end part in one direction or from opposing two end parts toward a center (center between the two end parts), with the contractible film layer side being inside, with lifting up the outer edge (end part) by the action of contraction force of the contractible film and repulsion force against the contraction force of the contractible film as a driving force when a stimulus such as heat is applied and thus the pressure-sensitive adhesive sheet can be extremely easily and cleanly peeled from the adherend without damaging the adherend by the stress at peeling. In this regard, in the invention, the formation of the cylindrical roll by spontaneous contraction when a stimulus such as heat that causes contraction is applied is referred to as "spontaneous rolling".

Further, the inventors have found that the warpage after wafer thinning can be greatly reduced by providing an intermediate layer having a specific shear elastic modulus between the above-mentioned rigid film layer and pressure-sensitive adhesive layer. Specifically, when a pressure-sensitive adhesive sheet having a five-layer structure of contractible film layer/elastic layer/rigid film layer/intermediate layer/pressure-sensitive adhesive layer is stuck on an 8-inch mirror wafer and the wafer is ground to a thickness of 25 µm, it had been found that the wafer hardly generates warpage and can be conveyed without any damage. It is considered that this is because the intermediate layer relieves the tensile stress of the composite backing material composed of contractible film layer/elastic layer/rigid film layer.

Namely, the invention provides a pressure-sensitive adhesive sheet with spontaneously rolling property, comprising a contractible film layer, an elastic layer, a rigid film layer, an intermediate layer, and a pressure-sensitive adhesive layer satisfying the following requirements and laminated in this order, which is capable of undergoing spontaneous rolling from one end part in one direction or from opposing two end parts toward a center to form one or two cylindrical rolls when a stimulus causing a contraction is applied:
the elastic layer having a thickness of from 15 to 150 µm and a shear modulus at 80°C of from 1×10⁴ Pa to 5×10⁶ Pa,
the intermediate layer having a shear modulus at 23°C of from 1×10⁴ Pa to 4×10⁷ Pa, and
the pressure-sensitive adhesive layer having a pressure-sensitive adhesive strength of the pressure-sensitive adhesive layer or the pressure-sensitive adhesive layer after an adhesion reducing treatment (180° peeling, vs. silicon mirror wafer, tensile rate: 300 mm/minute) of 6.5 N/10 mm or less.

The above-mentioned contractible film layer is preferably composed of a heat contractible film of which heat contraction ratio in the main contraction direction at a predetermined temperature ranging from 70 to 180°C is from 30 to 90%. In this regard, in the present specification, the contraction ratio (%) means a value calculated based on an equation: [(size before contraction - size after contraction)/(size before contraction)] × 100 and represents a contraction ratio in the main contraction direction unless otherwise stated.

The product of the shear modulus of the elastic layer at 80°C and the thickness of the elastic layer preferably ranges from 1 to 1000 N/m.

The product of the Young's modulus of the rigid film layer at 80°C and the thickness of the rigid film layer is preferably 3.0×10⁵ N/m or less.

The ratio (r/L) of the diameter r of the cylindrical roll formed by spontaneous rolling when the pressure-sensitive adhesive sheet with spontaneously rolling property is contracted by applying the stimulus that causes the contraction to the sheet relative to the length L of the pressure-sensitive adhesive sheet with spontaneously rolling property in the rolling direction preferably ranges from 0.001 to 0.333. In this regard, the pressure-sensitive adhesive sheet with spontaneously rolling property in the invention similarly rolls even when the length L of the sheet in the rolling direction increases. Therefore, the lower limit of r/L decreases as the length L of the sheet in the rolling direction increases.

### Advantage of the Invention

According to the pressure-sensitive adhesive sheet with spontaneously rolling property of the invention, even when a temporarily fixed adherend is ground as thin as a thickness of 100 µm or less, the generation of warpage in the adherend can be suppressed and, after subjected to a desired treatment such as grinding, the sheet is impelled by applying a stimulus such as heat that causes contraction to spontaneously roll from an end part (one end part or opposing two end parts) normally in the main contraction axis direction with peeling from the adherend, thereby a cylindrical roll being spontaneously formed, so that the sheet can be extremely easily removed from the adherend surface without damaging the adherend and staining the adherend owing to imperfect peeling. Therefore, in particular, the sheet is useful as a pressure-sensitive adhesive sheet for temporarily fixing to be stuck on an adherend which may be thinly ground.

### Brief Description of the Drawings

[Fig. 1] It is a schematic cross-sectional view showing one example of the pressure-sensitive adhesive sheet with spontaneously rolling property of the present invention.
[Fig. 2] It includes views (perspective views) showing how the pressure-sensitive adhesive sheet with spontaneously rolling property of the present invention undergoes spontaneous rolling.
[Fig. 3] It includes views (side views) showing one example of the processing process of an adherent utilizing the pressure-sensitive adhesive sheet with spontaneously rolling property of the present invention.

### Mode for Carrying Out the Invention

The pressure-sensitive adhesive sheet with spontaneously rolling property of the present invention is a pressure-sensitive adhesive sheet comprising a contractible film layer, an elastic layer and a rigid film layer as a restriction layer, an intermediate layer, and a pressure-sensitive adhesive layer laminated in this order, which is capable of undergoing spontaneous rolling from one end part in one direction or from opposing two end parts toward a center to form one or two cylindrical rolls.

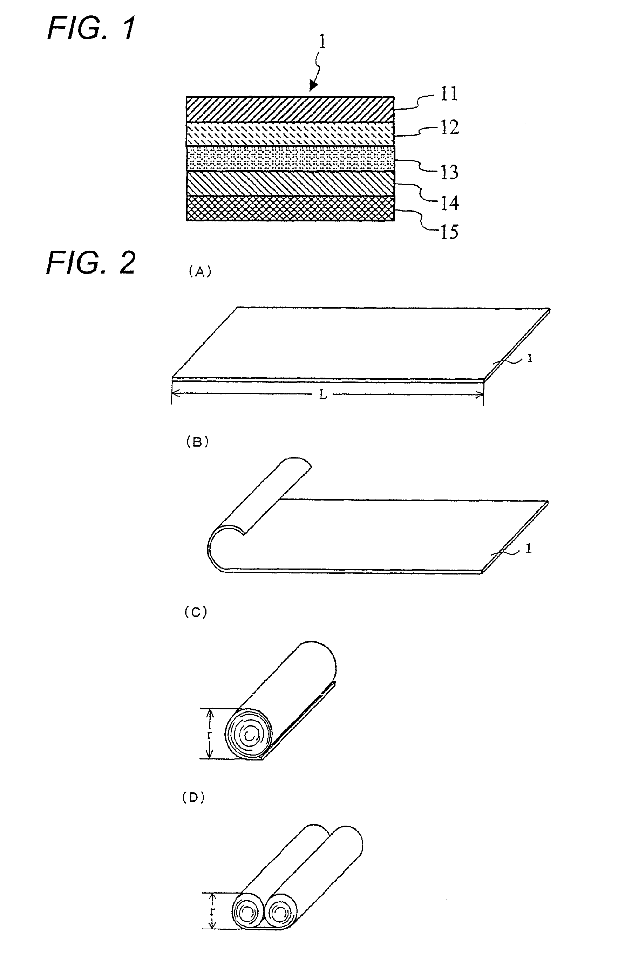

Fig. 1 is a schematic cross-sectional view showing one example of the pressure-sensitive adhesive sheet with spontaneously rolling property of the present invention. In the pressure-sensitive adhesive sheet 1 with spontaneously rolling property shown in Fig. 1, a contractible film layer 11, an elastic layer 12 and a rigid film layer 13 as a restriction layer restricting the contraction of the contractible film layer 11, an intermediate layer 14, and a pressure-sensitive adhesive layer 15 are laminated in the order.

### [Contractible Film Layer]

The contractible film layer may be sufficient to be a film layer having contractibility in at least one axis direction, and may be composed of any of a heat contractible film, a film exhibiting contractibility by light, a film contracting by an electric stimulus, and the like. Above all, from the viewpoint of working efficiency and the like, the layer is preferably composed of a heat contractible film. The contractible film layer may have contractibility only in one direction or may have main contractibility in a certain direction (one axis direction) and have secondary contractibility in a different direction (for example, a direction perpendicular to the direction above). Also, the contractible film layer may be a single layer or a multilayer composed of two or more layers.

The contraction ratio in the main contraction direction of the contractible film constituting the contractible film layer is preferably from 30 to 90%. In the case where the contractible film layer is composed of a heat contractible film, the contraction ratio in the main contraction direction of the contractible film is preferably from 30 to 90% at a predetermined temperature in the range of 70 to 180°C (for example, 95°C, 140°C, etc.). The contraction ratio in a direction other than the main contraction direction of the contractible film constituting the contractible film layer is preferably 10% or less, further preferably 5% or less, particularly preferably 3% or less. Heat contractibility of the heat contractible film can be imparted, for example, by subjecting a film extruded by an extruder to a stretching treatment.

Examples of the heat contractible film include uniaxially stretched films composed of one resin or two or more resins selected from polyesters such as polyethylene terephthalate, polyolefins such as polyethylene and polypropylene, polynorbomene, polyimides, polyamides, polyurethane, polystyrene, polyvinylidene chloride, polyvinyl chloride, and the like. Above all, the heat contractible film is preferably a uniaxially stretched film composed of a polyester-based resin, a polyolefin-based resin (including a cyclic polyolefin-based resin) such as polyethylene, polypropylene and polynorbomene, or a polyurethane-based resin in view of excellent workability in coating of the pressure-sensitive adhesive. As such a contractible film, it is possible to utilize commercially available products such as "SPACECLEAN" manufactured by Toyobo Co., Ltd., "FANCYWRAP" manufactured by Gunze Ltd., "TORAYFAN" manufactured by Toray Industries, Inc., "Lumirror" manufactured by Toray Industries, Inc., "ARTON" manufactured by JSR Corp., "ZEONOR" manufactured by ZEON Corp., and "SUNTEC" manufactured by Asahi Chemical Industry Co., Ltd.

In the case where the elastic layer and/or the pressure-sensitive adhesive layer of the pressure-sensitive adhesive sheet with spontaneously rolling property is an elastic layer and/or a pressure-sensitive adhesive layer formed using an active energy ray-curable pressure-sensitive adhesive, it is necessary to compose the contractible film layer by a material suitable for letting at least a predetermined amount of an active energy ray easily pass through (for example, a resin having transparency or the like) when irradiation with an active energy ray is performed through the contractible film layer at curing the elastic layer and/or the pressure-sensitive adhesive layer.

The thickness of the contractible film layer is generally from 5 to 300 µm, preferably from 10 to 100 µm. When the thickness of the contractible film layer is excessively large, rigidity increases to disallow spontaneous rolling or separation between the heat contractible layer and the restriction layer may be generated, which is liable to result in laminate fracture. Moreover, it is known that a film having a large rigidity exhibits a large elastic deformation force which is generated by a remaining stress at tape sticking and results in a large warpage when a wafer is thinned. The surface of the contractible film layer may be subjected to a conventional surface treatment, e.g., a chemical or physical treatment such as a chromium acid treatment, ozone exposure, flame exposure, high-pressure electric shock exposure or an ionized radiation treatment, a coating treatment with an undercoat agent (e.g., a tacky substance or the like) so as to enhance the close-adhesiveness, holding ability, and the like with the adjacent layer.

### [Restriction Layer]

The restriction layer restricts contraction of the contractible film layer to yield a reaction force, and the laminate as a whole thereby produces a couple of force, which works out to a driving force of inducing rolling. Moreover, secondary contraction in the direction different from the main contraction direction of the contractible film layer is suppressed by the restriction layer, and it is considered that the restriction layer also has a function that the contraction directions of the contractible film layer which has uniaxial contractibility but has not necessarily uniform contractibility are converged to one direction. Therefore, when a stimulus promoting the contraction of the contractible film layer, e.g., heat, is, for example, applied to the pressure-sensitive adhesive sheet, it is considered that the outer edge (one end part or opposing two end parts) of the pressure-sensitive adhesive sheet is lifted up by the action of the repulsion force against the contraction force of the contractible film in the restriction layer as a driving force to form a cylindrical roll through spontaneous rolling from one end part in one direction or in the center direction (usually, main contraction axis direction of the contractible film layer), with the contractible film layer side being inside. Moreover, since transmission of the shear force generated by the contraction deformation of the contractible film layer can be prevented by the restriction layer, the breakage of the pressure-sensitive adhesive layer having a decreased pressure-sensitive adhesive strength at re-peeling (e.g., a cured pressure-sensitive adhesive layer), the breakage of the adherend, the staining of the adherend with the broken pressure-sensitive adhesive layer, and the like can be prevented.

For exhibiting a function of restricting the contraction of the contractible film layer, the restriction layer has adhesiveness (including pressure-sensitive adhesiveness) with respect to the elastic layer and contractible film layer. Also, for smooth formation of the cylindrical roll, the restriction layer preferably possesses a certain degree of toughness or rigidity. The restriction layer in the invention is composed of the elastic layer and the rigid film layer.

### [Elastic Layer]

The elastic layer is preferably easily deformable under the temperature at the contraction of the contractible film layer, that is, preferably in a rubbery state. However, with a material having fluidity, a sufficient reaction force is not yielded, and the contractible film layer alone is finally caused to undergo contraction, failing in bringing about deformation (spontaneous rolling). Accordingly, the elastic layer is preferably a layer whose fluidity is suppressed by three-dimensional crosslinking or the like. Also, depending on the thickness, the elastic layer has an action of standing against a weaker force component out of non-uniform contraction forces of the contractible film layer and preventing the contraction deformation by the weaker force component, thereby converting the contraction to a uniform contraction direction. It is considered that the warpage yielded after wafer grinding is generated by a residual stress, which is a stress remaining at the sticking of the pressure-sensitive adhesive sheet on a wafer, but the elastic layer also has a function of relieving the residual stress to decrease the warpage.

The shear modulus of the elastic layer in the invention is from 1×10⁴ to 5×10⁶ Pa, preferably from 0.05×10⁶ to 3×10⁶ Pa, at the temperature at peeling (for example, 80°C). When the shear modulus is too small, the action to convert a contraction stress of the contractible film layer into a stress necessary for rolling is insufficient, whereas when it is excessively large, rigidity is strengthened to impair the rolling property and additionally, an elastic layer having high elasticity generally lacks adhesiveness, making it difficult to produce a laminate, and also is poor in the action to relieve the residual stress.

The thickness of the elastic layer is from 15 to 150 µm. When the thickness is too small, a restriction property against the contraction of the contractible film layer can be hardly obtained and the effect of relieving a stress also decreases. On the other hand, when it is excessively large, the spontaneously rolling property tends to be lowered, or handleability and profitability are poor, so that the case is not preferred.

Accordingly, the product of the shear modulus of the elastic layer (for example, the value at 80°C) and the thickness of the elastic layer (shear modulus × thickness) is preferably from 1 to 1000 N/m, more preferably from 1 to 150 N/m, further preferably from 1.2 to 100 N/m.

Moreover, the elastic layer is preferably formed of a resin having pressure-sensitive adhesiveness and having a glass transition temperature of, for example, 50°C or less, preferably room temperature (25°C) or less, more preferably 0°C or less. The pressure-sensitive adhesive strength of the elastic layer surface on the contractible film layer side is preferably in the range of 0.5 N/10 mm or more as a value in a 180° peeling test (in accordance with JIS Z 0237, tensile rate: 300 mm/min, 50°C). When this pressure-sensitive adhesive strength is too low, separation is liable to occur between the contractible film layer and the elastic layer.

Furthermore, in the case where the pressure-sensitive adhesive layer is an active energy ray-curable pressure-sensitive adhesive layer, the elastic layer is preferably formed of a material suitable for letting an active energy ray easily pass through and preferably has excellent formability which allows appropriate selection of the thickness and easy formation into a film shape from the viewpoints of production, workability and the like.

As the elastic layer, there can be used a foam material (foamed film) such as urethane foam and acrylic foam whose surface (at least the surface on the contractible film layer side) is subjected to a pressure-sensitive adhesive treatment and a resin film (including a sheet) such as non-foamed resin film using rubber, thermoplastic elastomer or the like as a material. The pressure-sensitive adhesive for use in the pressure-sensitive adhesive treatment is not particularly limited and, for example, one of known pressure-sensitive adhesives such as acrylic pressure-sensitive adhesives, rubber-based pressure-sensitive adhesives, vinyl alkyl ether-based pressure-sensitive adhesives, silicone-based pressure-sensitive adhesives, polyester-based pressure-sensitive adhesives, polyamide-based pressure-sensitive adhesives, urethane-based pressure-sensitive adhesives and styrene-diene block copolymer-based pressure-sensitive adhesives may be used, or two or more thereof may be used in combination. Above all, an acrylic pressure-sensitive adhesive is preferably used from the viewpoint of adjusting the adhesive strength or the like. Incidentally, the resin of the pressure-sensitive adhesive for use in the pressure-sensitive adhesive treatment and the resin of the foamed film or non-foamed resin film are preferably the same type of resins so as to obtain high affinity. For example, in the case of using an acrylic pressure-sensitive adhesive for the pressure-sensitive adhesive treatment, an acrylic foam or the like is suitable as the resin film.

Also, the elastic layer may be formed of, for example, a resin composition having adhesiveness by itself, such as a crosslinkable acrylic pressure-sensitive adhesive. Such a layer (pressure-sensitive adhesive layer) formed of a crosslinkable acrylic pressure-sensitive adhesive or the like can be produced by a relatively simple and easy method without the need to separately apply an adhesive treatment and is preferably used because of its excellence in the productivity and profitability.

The crosslinkable acrylic pressure-sensitive adhesive has a constitution such that a crosslinking agent is added to an acrylic pressure-sensitive adhesive using an acrylic polymer as the base polymer. Examples of the acrylic polymer include a homo-or co-polymer of an alkyl (meth)acrylate such as C₁-C₂₀ alkyl (meth)acrylate, e.g., methyl (meth)acrylate, ethyl (meth)acrylate, butyl (meth)acrylate, 2-ethylhexyl (meth)acrylate, octyl (meth)acrylate; and a copolymer of an alkyl (meth)acrylate described above and other copolymerizable monomers [for example, a carboxyl group-or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholyl (meth)acrylate; an amide group-containing monomer such as (meth)acrylamide; a cyano group-containing monomer such as (meth)acrylonitrile; and a (meth)acrylic acid ester having an alicyclic hydrocarbon group, such as isobornyl (meth)acrylate].

In particular, the acrylic polymer is preferably a copolymer of one kind or two or more kinds of C₁-C₁₂ alkyl (meth)acrylates such as ethyl acrylate, butyl acrylate and 2-ethylhexyl acrylate and at least one kind of a copolymerizable monomer selected from a hydroxyl group-containing monomer such as 2-hydroxyethyl acrylate and a carboxyl group- or acid anhydride group-containing monomer such as acrylic acid, or a copolymer of one kind or two or more kinds of C₁-C₁₂ alkyl (meth)acrylates, an alicyclic hydrocarbon group-containing (meth)acrylic acid ester, and at least one kind of a copolymerizable monomer selected from a hydroxyl group-containing monomer and a carboxyl group- or acid anhydride group-containing monomer.

The acrylic polymer is prepared as a high-viscosity liquid prepolymer, for example, by polymerizing a monomer component exemplified above (and a polymerization initiator) with light (e.g., ultraviolet ray) in the absence of a solvent. A crosslinking agent is then added to this prepolymer, whereby a crosslinkable acrylic pressure-sensitive adhesive composition can be obtained. Here, the crosslinking agent may be added at the production of the prepolymer. The crosslinkable acrylic pressure-sensitive adhesive composition may also be obtained by adding a crosslinking agent and a solvent (it is not necessarily required in the case where an acrylic polymer solution is used) to an acrylic polymer obtained by the polymerization of a monomer component exemplified above or to a solution thereof.

The crosslinking agent is not particularly limited and, for example, an isocyanate-based crosslinking agent, a melamine-based crosslinking agent, an epoxy-based crosslinking agent, an acrylate-based crosslinking agent (polyfunctional acrylate), a (meth)acrylic acid ester having an isocyanate group, or the like may be used. Examples of the acrylate-based crosslinking agent include hexanediol diacrylate, 1,4-butanediol diacrylate, trimethylolpropane triacrylate, pentaerythritol tetraacrylate and dipentaerythritol hexaacrylate. Examples of the (meth)acrylic acid ester having an isocyanate group include 2-isocyanatoethyl acrylate and 2-isocyanatoethyl methacrylate. Above all, the crosslinking agent is preferably an ultraviolet ray (UV)-reactive crosslinking agent such as an acrylate-based crosslinking agent (polyfunctional acrylate) or (meth)acrylic acid ester having an isocyanate group. The amount of the crosslinking agent added is usually on the order of 0.01 to 15 parts by mass, preferably on the order of 0.05 to 12 parts by mass per 100 parts by mass of the base polymer.

The crosslinkable acrylic pressure-sensitive adhesive may contain, in addition to the base polymer and the crosslinking agent, appropriate additives such as a crosslinking accelerator, a tackifier (e.g., a rosin derivative resin, a polyterpene resin, a petroleum resin, an oil-soluble phenol resin), a thickener, a plasticizer, a filler, an antiaging agent and an antioxidant.

With respect to the crosslinked acrylic pressure-sensitive adhesive layer as the elastic layer, for example, a crosslinkable acrylic pressure-sensitive adhesive composition prepared by adding a crosslinking agent to the above-described prepolymer is formed into a film shape having a desired thickness and a desired area by a known method such as casting method, and a crosslinking reaction (and polymerization of an unreacted monomer) is allowed to proceed by again irradiating the film with light, whereby an elastic layer appropriate to the purpose can be easily and simply obtained. The elastic layer (crosslinked acrylic pressure-sensitive adhesive layer) thus obtained has self-pressure-sensitive adhesiveness and therefore, can be directly used by laminating it between the contractible film layer and the rigid film layer.

The crosslinked acrylic pressure-sensitive adhesive layer as the elastic layer may also be obtained by coating a crosslinkable acrylic pressure-sensitive adhesive composition, which is obtained by dissolving the above-described acrylic polymer and crosslinking agent in a solvent, on a surface of the rigid film layer, sticking the contractible film layer thereon, and then irradiating the resulting laminate with light. Incidentally, in the case where the pressure-sensitive adhesive layer is an active energy ray-curable pressure-sensitive adhesive layer, the crosslinkable acrylic pressure-sensitive adhesive may be cured (crosslinked) by irradiation with an active energy ray (irradiation with light) at the time when the pressure-sensitive adhesive layer is cured at re-peeling.

To the components constituting the elastic layer in the present invention, beads such as glass bead and resin bead may be further added. Addition of glass or resin beads to the elastic layer is advantageous in that control of the pressure-sensitive adhesiveness and the shear modulus is facilitated. The average particle diameter of the beads is, for example, from 1 to 100 µm, preferably on the order of 1 to 20 µm. The amount of the beads added is, for example, from 0.1 to 10 parts by mass, preferably from 1 to 4 parts by mass, per 100 parts by mass of the entire elastic layer. When the amount added is excessively large, the pressure-sensitive adhesiveness may be deteriorated, whereas when it is too small, the above-described effect tends to be insufficient.

### [Rigid Film Layer (Rigid Backing Material)]

The rigid film layer has a function of imparting rigidity or toughness to the restriction layer, thereby yielding a reaction force for the contraction force of the contractible film layer, and in turn, generating a couple of force necessary for rolling. By virtue of providing the rigid film layer, when a stimulus such as heat that causes contraction is applied to the contractible film layer, the pressure-sensitive adhesive sheet smoothly undergoes spontaneous rolling without stopping halfway or shifting the direction and can form a neatly shaped cylindrical roll.

Examples of the rigid film constituting the rigid film layer includes a film composed of one kind or two or more kinds of resins selected from a polyester such as polyethylene terephthalate, polybutylene terephthalate and polyethylene naphthalate; a polyolefin such as polyethylene and polypropylene; polyimide; polyamide; polyurethane; a styrene-based resin such as polystyrene; polyvinylidene chloride; and polyvinyl chloride. Above all, a polyester-based resin film, a polypropylene film, a polyamide film and the like are preferred in that, for example, the coating workability of a pressure-sensitive adhesive is excellent. The rigid film layer may be either a single layer or a multilayer in which two or more layers are laminated. The rigid film constituting the rigid film layer is preferably non-contractible and, for example, the contraction ratio is, for example, 5% or less, preferably 3% or less, more preferably 1% or less.

The thickness of the rigid film layer is, for example, from 20 to 150 µm, preferably from 25 to 95 µm, more preferably from 30 to 90 µm, particularly preferably on the order of 30 to 80 µm. When the thickness is too small, it is difficult to obtain a neatly shaped cylindrical roll, whereas when it is excessively large, the spontaneously rolling property is decreased and the handleability and profitability are poor, which are not preferred.

The product of the Young's modulus and the thickness (Young's modulus × thickness) of the rigid film layer is preferably 3.0×10⁵ N/m or less (for example, from 1.0×10² to 3.0×10⁵ N/m), more preferably 2.8×10⁵ N/m or less (for example, from 1.0×10³ to 2.8×10⁵ N/m), at the temperature upon peeling (for example, 80°C). When the product of the Young's modulus and the thickness of the rigid film layer is too small, the action to convert a contraction stress of the contractible film layer into a rolling stress is poor and the directional converging action is also likely to decrease, whereas when it is excessively large, rolling is liable to be suppressed by the rigidity. The Young's modulus of the rigid film layer is preferably from 3×10⁶ to 2×10¹⁰ N/m², more preferably from 1×10⁸ to 1×10¹⁰ N/m², at the temperature upon peeling (for example, 80°C). When the Young's modulus is too small, it is difficult to obtain a neatly shaped cylindrical roll, whereas when it is excessively large, the spontaneous rolling can hardly occur.

In the case where the pressure-sensitive adhesive layer is an active energy ray-curable pressure-sensitive adhesive layer, the rigid film layer is preferably formed of a material suitable for letting an active energy ray easily pass through and preferably has excellent formability which allows appropriate selection of the thickness and easy formation into a film shape from the viewpoints of production, workability and the like. For the rigid film layer in the invention, it is possible to utilize commercially available products such as trade name "Lumirror" (manufactured by Toray Industries, Inc.), trade name "TORAYFAN" (manufactured by Toray Industries, Inc.), trade name "TEONEX" manufactured by Teijin Ltd., and trade name "CAPTON" manufactured by Toray DuPont Ltd.

### [Pressure-Sensitive Adhesive Layer]

The pressure-sensitive adhesive layer in the invention preferably exhibits a sufficient pressure-sensitive adhesive strength for holding and temporarily fixing a wafer at the time when the wafer is subjected to a processing treatment such as grinding and is preferably capable of undergoing spontaneous rolling and thereby being peeled off without damaging the wafer and without generating adhesive residue after the completion of the processing treatment. The pressure-sensitive adhesive layer is characterized in that the pressure-sensitive adhesive strength (180° peeling, vs. silicon mirror wafer, tensile rate: 300 mm/min) of the pressure-sensitive adhesive layer at peeling is, for example, at ordinary temperature (25°C), 6.5 N/10 mm or less, particularly 6.0 N/10 mm or less.

As the pressure-sensitive adhesive layer, a pressure-sensitive adhesive layer originally having small adhesive strength can be also used but, preferred is a re-peelable pressure-sensitive adhesive layer having a pressure-sensitive adhesiveness enough to enable sure sticking to an adherend and, after the completion of the predetermined role, allowing the pressure-sensitive adhesiveness to be decreased or lost by a certain method (an adhesion reducing treatment). Such a re-peelable pressure-sensitive adhesive layer can have the same constitution as that of the pressure-sensitive adhesive layer of a known re-peelable pressure-sensitive adhesive sheet.

The pressure-sensitive adhesive layer is particularly preferably an active energy ray-curable pressure-sensitive adhesive layer. The active energy ray-curable pressure-sensitive adhesive layer may be composed of a material that has adhesiveness/pressure-sensitive adhesiveness in the early stage but forms a three-dimensional network structure upon irradiation of an active energy ray such as infrared ray, visible ray, ultraviolet ray, X-ray and electron beam to exhibit high elasticity, and an active energy ray-curable pressure-sensitive adhesive or the like may be used as such a material. The active energy ray-curable pressure-sensitive adhesive contains a compound chemically modified with an active energy ray reactive functional group for imparting active energy ray curability, or an active energy ray-curable compound (or an active energy ray-curing resin). Accordingly, there is preferably used an active energy ray-curable pressure-sensitive adhesive composed of a base material chemically modified with an active energy ray reactive functional group or a composition in which an active energy ray-curable compound (or an active energy ray-curble resin) is blended in the base material.

As the base material, for example, a pressure-sensitive adhesive material such as a conventionally known pressure-sensitive adhesive (adhesive) can be used. Examples of the pressure-sensitive adhesive include a rubber-based pressure-sensitive adhesive using, as the base polymer, natural rubber or a rubber-based polymer such as polyisobutylene rubber, styrene-butadiene rubber, styrene-isoprene-styrene block copolymer rubber, regenerated rubber, butyl rubber, polyisobutylene rubber and NBR; a silicone-based pressure-sensitive adhesive; and an acrylic pressure-sensitive adhesive. Among these, an acrylic pressure-sensitive adhesive is preferred. The base material may be composed of one kind or two or more kinds of components.

Examples of the acrylic pressure-sensitive adhesive include an acrylic pressure-sensitive adhesive using, as the base polymer, an acrylic polymer, for example, a homo- or co-polymer of an alkyl (meth)acrylate, such as C₁-C₂₀ alkyl (meth)acrylate, e.g., methyl (meth)acrylate, ethyl (meth)acrylate, butyl (meth)acrylate, t-butyl (meth)acrylate, 2-ethylhexyl (meth)acrylate, octyl (meth)acrylate; or a copolymer of the alkyl (meth)acrylate and other copolymerizable monomers [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide]. One of these may be used alone, or two or more thereof may be used in combination.

The active energy ray reactive functional group used for chemical modification to ensure active energy ray curing of an active energy ray-curable adhesive and the active energy ray-curable compound are not particularly limited as long as they are curable with an active energy ray such as infrared ray, visible ray, ultraviolet ray, X-ray and electron beam, but those capable of efficiently causing three-dimensional network formation (networking) of the active energy ray-curable pressure-sensitive adhesive after irradiation with an active energy ray are preferred. One of these may be used alone, or two or more thereof may be used in combination. Examples of the active energy ray reactive functional group for use in the chemical modification include a carbon-carbon multiple bond-containing functional group such as an acryloyl group, a methacryloyl group, a vinyl group, an allyl group and an acetylene group. Such a functional group can produce a radical resulting from cleavage of the carbon-carbon multiple bond upon irradiation with an active energy ray and form a three-dimensional network structure by letting the radical work out to a crosslinking point. Above all, a (meth)acryloyl group is preferred, in view of reactivity and workability, in that it can exhibit relatively high reactivity for an active energy ray and their use in combination is possible with selection from an abundant variety of acrylic pressure-sensitive adhesives.

Typical examples of the base material chemically modified with an active energy ray reactive functional group include a polymer obtained by reacting a reactive functional group-containing acrylic polymer resulting from copolymerization between a monomer containing a reactive functional group such as a hydroxyl group or a carboxyl group [e.g., 2-hydroxyethyl (meth)acrylate or (meth)acrylic acid] and an alkyl (meth)acrylate, with a compound having in its molecule a group capable of reacting with the reactive functional group (isocyanate group, epoxy group, or the like) and an active energy ray reactive functional group (acryloyl group, methacryloyl group, or the like) [e.g., (meth)acryloyloxyethylene isocyanate].

The ratio of the reactive functional group-containing monomer in the reactive functional group-containing acrylic polymer is, for example, from 5 to 40% by mass, preferably from 10 to 30% by mass, based on all monomers. At the reaction with the reactive functional group-containing acrylic polymer, the use amount of the compound having in its molecule a group capable of reacting with the reactive functional group and an active energy ray reactive functional group is, for example, from 50 to 100% by mol, preferably from 60 to 95% by mol, based on the reactive functional group (hydroxyl group, carboxyl group, or the like) in the reactive functional group-containing acrylic polymer.

Examples of the active energy ray-curable compound include a compound having two or more carbon-carbon double bonds, such as poly(meth)acryloyl group-containing compound, e.g., trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate, polyethylene glycol diacrylate or the like. One of these compounds may be used alone, or two or more thereof may be used in combination. Above all, a poly(meth)acryloyl group-containing compound is preferred, and examples thereof are described, for example, in JP-A-2003-292916. The poly(meth)acryloyl group-containing compound is hereinafter sometimes referred to as an "acrylate-based crosslinking agent".

As the active energy ray-curable compound, a mixture of organic salts such as an onium salt and a compound having a plurality of heterocycles in its molecule may also be used. The mixture produces an ion resulting from cleavage of an organic salt upon irradiation with an active energy ray and causes a ring-opening reaction of heterocycles by letting the produced ion work as an initiation species, whereby a three-dimensional network structure can be formed. Examples of the organic salts include an iodonium salt, a phosphonium salt, an antimonium salt, a sulfonium salt and a borate salt, and the heterocycles in the compound having a plurality of heterocycles in its molecule include oxirane, oxetane, oxolane, thiirane, aziridine, and the like. Specifically, compounds described in Hikari Koka Gijutsu, edited by Gijutsu Joho Kyokai, (2000) can be used.

Examples of the active energy ray curable resin include a photosensitive reactive group-containing polymer or oligomer such as an ester (meth)acrylate having a (meth)acryloyl group at its molecular end, a urethane (meth)acrylate, an epoxy (meth)acrylate, a melamine (meth)acrylate, an acrylic resin (meth)acrylate, a thiol-ene addition-type or cationic photopolymerization-type resin having an allyl group at its molecular end, a cinnamoyl group-containing polymer such as polyvinyl cinnamate, a diazotized amino-novolak resin, and an acrylamide-type polymer. Furthermore, examples of the polymer capable of reacting with a highly active energy ray include epoxidized polybutadiene, an unsaturated polyester, polyglycidyl methacrylate, polyacrylamide, polyvinylsiloxane and the like. Incidentally, in the case of using an active energy ray-curable resin, the base material described above is not necessarily required.

In particular, the active energy ray-curable pressure-sensitive adhesive is preferably one composed of a combination of the above-described acrylic polymer or acrylic polymer chemically modified with an active energy ray reactive functional group (an acrylic polymer where an active energy ray reactive functional group is introduced into the side chain) and the above-described energy ray-curable compound (for example, a compound having two or more carbon-carbon double bonds). The combination described above is preferred in view of reactivity and workability, because an acrylate group exhibiting relatively high reactivity for an active energy ray is contained and selection from a variety of acrylic pressure-sensitive adhesives is allowed. Specific examples of such a combination include a combination of an acrylic polymer having an acrylate group introduced into the side chain and a compound having two or more carbon-carbon double bond-containing functional groups (particularly acrylate groups). As such a combination, those disclosed, for example, in JP-A-2003-292916 can be used.

Examples of the preparation method of the acrylic polymer having an acrylate group introduced into the side chain thereof include a method of bonding an isocyanate compound such as acryloyloxyethyl isocyanate or methacryloyloxyethyl isocyanate to an acrylic polymer containing a hydroxyl group in its side chain, through a urethane bond.

The amount of the active energy ray-curable compound to be blended is, for example, on the order of 0.5 to 200 parts by mass, preferably on the order of 5 to 180 parts by mass, more preferably on the order of 20 to 130 parts by mass, per 100 parts by mass of the base material (for example, the above-described acrylic polymer or acrylic polymer chemically modified with an active energy ray reactive functional group).

In the active energy ray-curable pressure-sensitive adhesive, for the purpose of increasing the reaction rate for forming a three-dimensional network structure, an active energy ray polymerization initiator for curing the compound that imparts active energy ray curability may be blended.

The active energy ray polymerization initiator can be appropriately selected from conventionally known or employed polymerization initiators according to the kind of the active energy ray used (for example, infrared ray, visible ray, ultraviolet ray, X-ray or electron beam). In view of working efficiency, a compound capable of initiating photopolymerization with ultraviolet ray is preferred. Typical examples of the active energy ray polymerization initiator include, but are not limited to, a ketone-based initiator such as benzophenone, acetophenone, quinone, naphthoquinone, anthraquinone or fluorenone; an azo-based initiator such as azobisisobutyronitrile; and a peroxide-based initiator such as benzoyl peroxide and perbenzoic acid. Examples of the commercially available product include trade names "IRGACURE 184", "IRGACURE 651 ", ""IRGACURE 2959" manufactured by Ciba Japan Corp.

One of these active energy ray polymerization initiators may be used alone, or two or more thereof may be mixed and used. The amount of the active energy ray polymerization initiator to be blended is usually on the order of 0.01 to 10 parts by mass, preferably on the order of 1 to 8 parts by mass, per 100 parts by mass of the above-described base material. Incidentally, together with the active energy ray polymerization initiator, an active energy ray polymerization accelerator may be used in combination, if necessary.

In the active energy ray-curable pressure-sensitive adhesive, other than the components described above, an appropriate additive for obtaining an appropriate pressure-sensitive adhesiveness before and after the active energy ray curing, such as a crosslinking agent, a curing (crosslinking) accelerator, a tackifier, a vulcanizing agent and a thickener, and an appropriate additive for enhancing the durability, such as an antiaging agent and an antioxidant, are blended, if necessary.

As a preferable active energy ray-curable pressure-sensitive adhesive, there may be used, for example, a composition in which an active energy ray-curable compound is blended in a base material (pressure-sensitive adhesive), preferably a UV-curable pressure-sensitive adhesive in which a UV-curable compound is blended in an acrylic pressure-sensitive adhesive. In particular, as a preferred embodiment of the active energy ray-curable pressure-sensitive adhesive, there may be used a UV-curable pressure-sensitive adhesive containing a side-chain acrylate-containing acrylic pressure-sensitive adhesive, an acrylate-based crosslinking agent (a poly(meth)acryloyl group-containing compound; a polyfunctional acrylate) and an ultraviolet ray polymerization initiator. The side-chain acrylate-containing acrylic pressure-sensitive adhesive means an acrylic polymer in which an acrylate group is introduced into the side chain, and the same as those described above can be prepared by the same method and utilized. The acrylate-based crosslinking agent is a low molecular compound exemplified above as the poly(meth)acryloyl group-containing compound. As the ultraviolet ray polymerization initiator, those exemplified above as typical active energy ray polymerization initiators can be used.

In addition, a non-energy ray-curable pressure-sensitive adhesive using the above-described acrylic pressure-sensitive adhesive as the base material may also be used as the pressure-sensitive adhesive constituting the pressure-sensitive adhesive layer. In this case, those having a pressure-sensitive adhesive strength smaller than the peeling stress at the production of a cylindrical roll are applicable, and for example, a pressure-sensitive adhesive having a pressure-sensitive adhesive strength of 6.5 N/10 mm or less (for example, from 0.05 to 6.5 N/10 mm, preferably from 0.2 to 6.5 N/10 mm), particularly 6.0 N/10 mm or less (for example, from 0.05 to 6.0 N/10 mm, preferably from 0.2 to 6.0 N/10 mm), in a 180° peeling test (room temperature (25°C)) using a silicon mirror wafer as an adherend, can be used.

As the non-energy ray-curable pressure-sensitive adhesive using an acrylic pressure-sensitive adhesive having small pressure-sensitive adhesive strength as the base material, there are preferably used an acrylic pressure-sensitive adhesive obtained by adding a crosslinking agent capable of reacting with the reactive functional group [for example, an isocyanate-based crosslinking agent, a melamine-based crosslinking agent or an epoxy-based crosslinking agent] to a copolymer of an alkyl (meth)acrylate [for example, a C₁-C₂₀ alkyl (meth)acrylate such as methyl (meth)acrylate, ethyl (meth)acrylate, butyl (meth)acrylate, 2-ethylhexyl (meth)acrylate or octyl (meth)acrylate], a reactive functional group-containing monomer [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholinyl (meth)acrylate; or an amide group-containing monomer such as (meth)acrylamide] and, if necessary, other copolymerizable monomers [for example, an alicyclic hydrocarbon group-containing (meth)acrylic acid ester such as isobornyl (meth)acrylate, acrylonitrile, and the like], followed by crosslinking.

The pressure-sensitive adhesive layer can be formed by a conventional method, for example, a method of coating a surface of the intermediate layer with a coating solution prepared by adding a pressure-sensitive adhesive, an active energy ray-curing compound and, if necessary, a solvent; a method of coating the above-described coating solution on an appropriate release liner (separator) to form a pressure-sensitive adhesive layer, and transferring (transfer-fixing) this layer onto the intermediate layer. In the case of formation by transfer, a void (air gap) sometimes remains at the interface with the intermediate layer. In this case, the void can be caused to diffuse and disappear by applying a warming/pressurization treatment such as an autoclave treatment. The pressure-sensitive adhesive layer may be either a single layer or a multlayer.

To the constituent components of the pressure-sensitive adhesive layer for use in the invention, beads such as glass beads and resin beads may be further added. When grass beads or resin beads are added to the pressure-sensitive adhesive layer, the shear modulus is readily increased to lower the adhesive strength. The average particle diameter of the beads is, for example, from 1 to 100 µm, preferably on the order of 1 to 20 µm. The amount of the beads added is, for example, from 25 to 200 parts by mass, preferably from 50 to 100 parts by mass, per 100 parts by mass of the entire pressure-sensitive adhesive layer. When the amount is excessively large, insufficient dispersion sometimes occurs, making it difficult to coat the pressure-sensitive adhesive, whereas when it is too small, the above-described effect tends to be insufficient.

The thickness of the pressure-sensitive adhesive layer is generally from 10 to 200 µm, preferably from 20 to 100 µm, more preferably from 30 to 60 µm. When the thickness is too small, the pressure-sensitive adhesive strength is insufficient and therefore, it becomes difficult to hold and temporarily fix the adherend, whereas when the thickness is excessively large, the case is unprofitable and also, the handleability tends to be poor.

### [Intermediate Layer]

The intermediate layer in the invention locates between the above-mentioned rigid film layer and the pressure-sensitive adhesive layer and is a layer having a function of relieving a tensile stress of a composite backing material composed of contractible film layer/elastic layer/rigid film layer to suppress warpage of the wafer which is generated upon grinding the wafer extremely thin, and the intermediate layer is characterized by exhibiting a low elastic modulus as compared with the above-mentioned rigid film layer.

The shear modulus of the intermediate layer at 23°C is on the order of 1×10⁴ Pa to 4×10⁷ Pa, preferably on the order of 1×10⁵ Pa to 2×10⁷ Pa, in view of easiness of sticking of the pressure-sensitive adhesive sheet and workability such as tape-cut. When the shear modulus at 23°C is less than 1×10⁴ Pa, there is a concern that the intermediate layer is protruded from circumference of the wafer by wafer grinding pressure to damage the wafer. Moreover, when the shear modulus at 23°C is more than 4×10⁷ Pa, there is a tendency that a function of suppressing the warpage decreases.

The thickness of the intermediate layer is preferably 10 µm or more, and above all, the thickness is preferably 30 µm or more, particularly preferably 50 µm or more. When the thickness of the intermediate layer is less than 10 µm, it tends to be difficult to effectively suppress the warpage of the wafer resulting from grinding. Moreover, in order to maintain grinding accuracy, the thickness of the intermediate layer is preferably less than 150 µm.

Furthermore, the intermediate layer preferably has not only a function of relieving the above-mentioned tensile stress but also a cushion function of absorbing unevenness on the wafer surface during grinding and the sum of the thickness of the intermediate layer and the thickness of the above-mentioned pressure-sensitive adhesive layer is preferably 30 µm or more, particularly preferably from 50 to 300 µm. On the other hand, when the sum of the thickness of the intermediate layer and the thickness of the above-mentioned pressure-sensitive adhesive layer is less than 30 µm, the pressure-sensitive adhesive strength with respect to the wafer tends to be insufficient and, since the unevenness on the wafer surface is not completely absorbed at sticking, there is a tendency that the wafer is damaged during grinding and the chipping of the wafer edge is liable to occur. Moreover, when the sum of the thickness of the intermediate layer and the thickness of the above-mentioned pressure-sensitive adhesive layer is more than 300 µm, the thickness accuracy decreases and the wafer is liable to be damaged during grinding and also the spontaneously rolling property tends to decrease.

The product of the shear modulus and the thickness (shear modulus × thickness) of the intermediate layer is, for example, preferably 15000 N/m or less (e.g., from 0.1 to 15000 N/m), preferably 3000 N/m or less (e.g., from 3 to 3000 N/m), particularly preferably about 1000 N/m or less (e.g., from 20 to 1000 N/m). When the product of the shear modulus and the thickness of the intermediate layer is exceedingly large, there is a tendency that it becomes difficult to relieve the tensile stress of the composite backing material composed of contractible film layer/elastic layer/rigid film layer and it becomes difficult to suppress the warpage of the wafer induced by grinding as well as there is a tendency that the wafer is damaged during grinding and the chipping of the wafer edge is liable to occur since the unevenness on the wafer surface is not completely absorbed owing to rigidity at the time of sticking. When the product of the shear modulus and the thickness of the intermediate layer is too small, the intermediate layer is protruded to the outside of the wafer and the chipping of the edge and the damaging are liable to occur. Furthermore, an action of lowering the rolling property is also brought about.

The material for forming the intermediate layer is not particularly limited and there may be, for example, pressure-sensitive adhesives mentioned in the pressure-sensitive adhesive layer, various soft resins such as polyethylene (PE), ethylene-vinyl alcohol copolymer (EVA) and ethylene-ethyl acrylate copolymer (EEA) that are generally called resin films, mixed resins of acrylic resins and urethane polymers, graft polymers of acrylic resins and natural rubber, and the like.

As the acrylic monomer forming the above-mentioned acrylic resins, an alkyl (meth)acrylate such as a C₁-C₂₀ alkyl (meth)acrylate, e.g., methyl (meth)acrylate, ethyl (meth)acrylate, butyl (meth)acrylate, t-butyl (meth)acrylate, 2-ethylhexyl (meth)acrylate, octyl (meth)acrylate, or the like may be used alone or the alkyl (meth)acrylate may be used as a mixture with a monomer copolymerizable with the alkyl (meth)acrylate [e.g., a carboxyl group- or acid anhydride group-containing monomer such as acrylic acid, methacrylic acid, itaconic acid, fumaric acid or maleic anhydride].

As the material for forming the intermediate layer in the invention, in particular, in view of close-adhesiveness with the rigid film layer, it is preferred to use a mixed resin of an acrylic resin and a urethane polymer or a graft polymer of an acrylic resin and a natural rubber and particularly, a mixed resin of an acrylic resin and a urethane polymer is preferred. Incidentally, the urethane polymer can be produced by a well-known conventional method.

For the purpose of enhancing the adhesiveness of the intermediate layer with the above-mentioned rigid film layer, an undercoat layer may be appropriately provided between the intermediate layer and the rigid film layer. Moreover, for the purpose of enhancing the adhesiveness of the intermediate layer with the above-mentioned pressure-sensitive adhesive layer, the surface of the intermediate layer can be subjected to a conventional physical or chemical treatment such as a mat treatment, a corona discharging treatment, a primer treatment, a crosslinking treatment (e.g., a chemical crosslinking treatment using a silane or the like) according to need.

The intermediate layer can be formed by a well-known conventional method depending on the material form. For example, in the case where the material shows a solution form, the intermediate layer can be formed by a method of coating on the rigid film layer surface or by applying the solution on an appropriate release liner (separator) to form an intermediate layer and transferring (transfer-fixing) this layer onto the rigid film layer. Moreover, in the case of using a soft resin or a mixed resin as the intermediate layer, there may be mentioned a method of extrusion-lamination of the resin on the rigid film layer, a method of dry lamination of the resin previously formed into a film form or sticking of the resin through an undercoat agent having adhesiveness/pressure-sensitive adhesiveness, or the like.

The pressure-sensitive adhesive sheet with spontaneously rolling property of the invention can be produced by superposing the contractible film layer, the elastic layer, the rigid film layer, the intermediate layer, and the pressure-sensitive adhesive layer and laminating them appropriately and selectively using a lamination device such a hand roller or a laminator or an atmospheric pressure compression device such as an autoclave depending on the purpose.

In the pressure-sensitive adhesive sheet with spontaneously rolling property of the invention, from the standpoint of protection, blocking prevention and the like of the pressure-sensitive adhesive layer surface, a separator (release liner) may be provided on the pressure-sensitive adhesive layer surface. The separator is peeled off when sticking the pressure-sensitive adhesive sheet with spontaneously rolling property to the adherend. The separator used is not particularly limited and a conventionally known and employed release paper or the like can be used. For Example, there can be used a backing material having a release layer, such as a plastic film or paper surface-treated with a release agent such as silicone type, long-chain alkyl type, fluorine type or molybdenum sulfide type; a low adhesive backing material composed of a fluorine-based polymer such as polytetrafluoroethylene, polychlorotrifluoroethylene, polyvinyl fluoride, polyvinylidene fluoride, tetrafluoroethylene-hexafluoropropylene copolymer or chlorofluoroethylene-vinylidene fluoride copolymer; and a low adhesive backing material composed of a non-polar polymer such as an olefin-based resin (e.g., polyethylene, polypropylene, or the like).

The pressure-sensitive adhesive sheet with spontaneously rolling property of the invention can be utilized as a pressure-sensitive adhesive sheet for protecting semiconductors and the like or a pressure-sensitive adhesive sheet for fixing semiconductor wafers and the like, and more specifically, for example, used as a pressure-sensitive adhesive sheet for silicon semiconductor back grind, a pressure-sensitive adhesive sheet for compound semiconductor back grind, a pressure-sensitive adhesive sheet for silicon semiconductor dicing, a pressure-sensitive adhesive sheet for compound semiconductor dicing, a pressure-sensitive adhesive sheet for semiconductor package dicing, a pressure-sensitive adhesive sheet for glass dicing, a pressure-sensitive adhesive sheet for ceramics dicing, and the like. Particularly, it is useful as a pressure-sensitive adhesive sheet for semiconductors such as a pressure-sensitive adhesive sheet for protecting semiconductors or a pressure-sensitive adhesive sheet for fixing semiconductor wafers.

### [Processing Method of Adherend]

The following will describe a processing method of an adherend using the pressure-sensitive adhesive sheet with spontaneously rolling property of the invention. The pressure-sensitive adhesive sheet with spontaneously rolling property of the invention is stuck to an adherend to effect temporary fixing. After the adherend (material to be processed) is subjected to a necessary processing, the pressure-sensitive adhesive strength of the pressure-sensitive adhesive layer of the pressure-sensitive adhesive sheet with spontaneously rolling property is lowered and also a stimulus such as heat that cause contraction of the contractible film layer is applied, so that the pressure-sensitive adhesive sheet with spontaneously rolling property is peeled from the adherend by spontaneous rolling from one end part of the sheet in one direction (usually, in the main contraction axis direction) or from opposing two end parts toward a center (usually, in the main contraction axis direction) to form one or two cylindrical rolls, whereby a processed product can be obtained. In this regard, in the case where the pressure-sensitive adhesive sheet with spontaneously rolling property undergoes spontaneous rolling from one end part of the sheet in one direction, one cylindrical roll is formed (peeling with one-direction rolling). In the case where the pressure-sensitive adhesive sheet with spontaneously rolling property undergoes spontaneous rolling from opposing two end parts toward a center, parallel two cylindrical rolls are formed (peeling with two-direction rolling).

Representative examples of the material to be processed include semiconductor wafers. The kinds of processing include, for example, grinding, cutting, abrading, etching, lathe processing, heating (however, limited to a temperature equal to or lower than heat-contraction starting temperature in the case where the contractible film layer is a heat contractible film layer), and the like and the processing is not particularly limited as long as it is a processing which can be performed using the pressure-sensitive adhesive sheet.

After the material to be processed is processed, for example, in the case where the pressure-sensitive adhesive layer and/or the elastic layer is formed of an active energy ray-curable pressure-sensitive adhesive, by irradiation with an active energy ray to the pressure-sensitive adhesive layer and/or the elastic layer, the pressure-sensitive adhesive layer is first cured to lose pressure-sensitive adhesive strength with respect to the adherend and also the elastic layer is cured to facilitate the transmission of the contraction stress of the contractible film to the rigid film layer, so that the spontaneously rolling property of the pressure-sensitive adhesive sheet with spontaneously rolling property can be more enhanced. Subsequently, in the case where the contractible film layer is a heat contractible film layer, when the heat contractible film layer is heated by a certain heating device, the contractible film layer is going to be contracted and deformed, so that the outer edge of the pressure-sensitive adhesive sheet is lifted and the pressure-sensitive adhesive sheet spontaneously runs in one direction (or in two directions whose directions are reverse each other (directions toward a center)) with rolling to form one (or two) cylindrical roll(s). On this occasion, since the contraction direction of the pressure-sensitive adhesive sheet is adjusted by the restriction layer composed of the elastic layer and the rigid film layer, a cylindrical roll is rapidly formed with rolling in one axis direction. Therefore, the pressure-sensitive adhesive sheet can be extremely easily and cleanly peeled from the adherend (material to be processed). The heating temperature can be appropriately selected depending on the contractibility of the heat contractible film layer and is, for example, from 70 to 180°C, preferably from 70 to 140°C. The irradiation with an active energy ray and the heating treatment may be performed simultaneously or stepwise. Moreover, the heating may be not only heating all over the adherend uniformly but also heating the whole surface stepwise or partial heating for making a peeling-start and should be appropriately selected depending on the purpose of utilizing the easy peelability.

Fig. 2 includes views (perspective views) showing how the pressure-sensitive adhesive sheet with spontaneously rolling property of the invention undergoes spontaneous rolling. Fig. 2(A) is a view showing the pressure-sensitive adhesive sheet with spontaneously rolling property before applying a stimulus that causes contraction of the contractible film layer; Fig. 2(B) is a view showing a state where the pressure-sensitive adhesive sheet with spontaneously rolling property to which a stimulus that causes contraction of the contractible film layer has been applied (pressure-sensitive adhesive sheet after the pressure-sensitive adhesive strength of the pressure-sensitive adhesive layer is lowered or lost) starts rolling from the outer edge (one end part) of the sheet in one direction (usually, in the main contraction axis direction of the contractible film layer); and Fig. 2(C) is a view showing a state where rolling of the sheet is completed and one cylindrical roll is formed (one-direction rolling). Moreover, Fig. 2(D) is a view showing a state where the sheet undergoes spontaneous rolling from two opposing end parts toward a center (usually, in the main contraction axis direction of the contractible film layer) to form two cylindrical rolls (two-direction rolling). Incidentally, whether the pressure-sensitive adhesive sheet with spontaneously rolling property causes one-direction rolling or two-direction rolling varies depending on the pressure-sensitive adhesive strength of the restriction layer with respect to the contractible film layer or the shear modulus of the restriction layer (particularly, the elastic layer).

In Fig. 2, the symbol L represents length (diameter in the case where the sheet is in a circular form) of the pressure-sensitive adhesive sheet 1 with spontaneously rolling property in the rolling direction (usually, in the main contraction axis direction of the contractible film layer) (see, Fig. 2(A)), the symbol r represents diameter of the cylindrical roll formed (maximum diameter in the case where the diameter of the cylindrical roll is not constant as in the case where the sheet is in a circular form or the like) (see, Fig. 2(C) and Fig. 2(D)). In the pressure-sensitive adhesive sheet with spontaneously rolling property of the invention, the value of r/L is preferably in the range of 0.001 to 0.333, more preferably in the range of 0.01 to 0.2. Incidentally, the length of L is, for example, from 10 to 2000 mm, preferably from 300 to 1000 mm. The length in the direction orthogonal to L in the pressure-sensitive adhesive sheet is, for example, from 10 to 2000 mm, preferably on the order of 300 to 1000 mm. The value of r/L can be set to the above-mentioned range by adjusting the kind of the material, composition, thickness and the like of each layer of the contractible film layer, the restriction layer (elastic layer and rigid film layer) and the pressure-sensitive adhesive layer, particularly the shear modulus and thickness of the elastic layer and the Young's modulus and thickness of the rigid film layer constituting the restriction layer. In this example, the shape of the pressure-sensitive adhesive sheet with spontaneously rolling property is quadrangular but is not limited thereto, can be appropriately selected depending on the purpose, and may be any of a circular form, a elliptical form, a polygonal form, and the like.

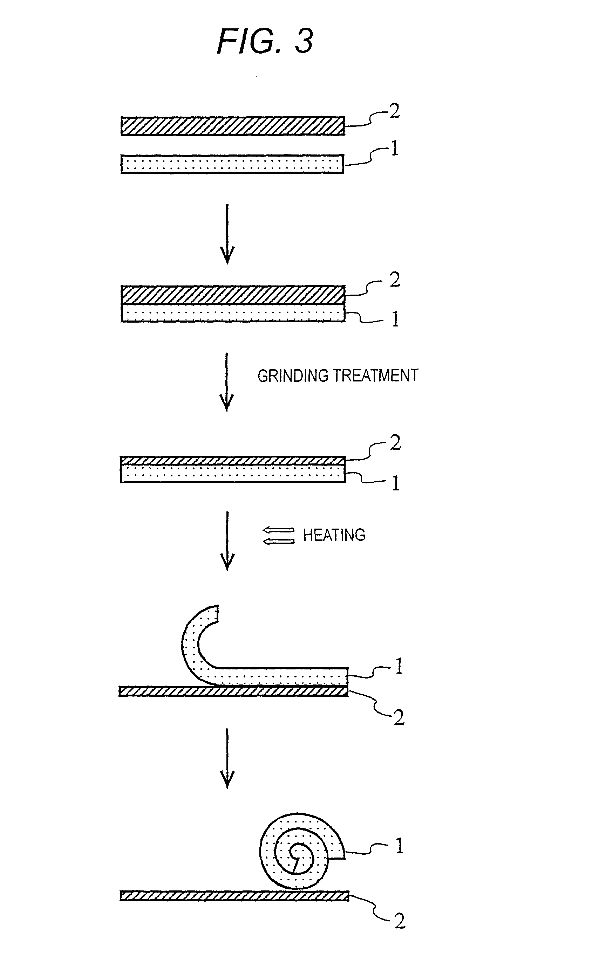

Fig. 3 includes views (side views) showing one example of the processing process of an adherend utilizing the pressure-sensitive adhesive sheet with spontaneously rolling property of the present invention and the process has following steps:
1. a pressure-sensitive adhesive sheet with spontaneous peelability (pressure-sensitive adhesive sheet with spontaneously rolling property) 1 is stuck on a semiconductor wafer 2;
2. the semiconductor wafer 2 having the pressure-sensitive adhesive sheet with spontaneous peelability 1 stuck thereon is subjected to a necessary processing (grinding treatment etc.); and
3. the pressure-sensitive adhesive sheet with spontaneous peelability is spontaneously rolled to form a cylindrical roll by performing a heating treatment or the like, thereby peeling the sheet from the semiconductor wafer 2.

When the pressure-sensitive adhesive sheet with spontaneously rolling property of the invention is used in the processing of the adherend (material to be processed), the generation of warpage in the adherend can be suppressed even when the adherend is ground as thin as 100 µm or less and the damage of the adherend during grinding and during conveyance can be prevented. Moreover, after the completion of the adherend processing, the sheet is impelled by applying a stimulus such as heat that causes contraction and undergoes spontaneous rolling from an end part (one end part or opposing two end parts) usually in the main contraction axis direction with peeling from the adherend to form a cylindrical roll, so that the damage of the adherend by the stress at the peeling can be avoided and the pressure-sensitive adhesive sheet can be easily peeled from the adherend without damage and staining.

### Examples

The present invention is described in greater detail below by referring to Examples, but the present invention is not limited to these Examples. Incidentally, the shear modulus of the elastic layer and that of the rigid film layer and the pressure-sensitive adhesive strength of the elastic layer with respect to the contractible film were measured as follows.

### [Measurement of Young's Modulus (80°C) of Rigid Film Layer (Rigid Backing Material)]

The Young's modulus of the rigid film layer was measured by the following method in accordance with JIS K7127.

An autograph fitted with a heating hood (trade name "AG-1kNG" manufactured by Shimadzu Corporation) was used as a tensile tester. A rigid film cut into a size having a length of 200 mm and a width of 10 mm was mounted at a chuck distance of 100 mm.

After the atmosphere was heated to 80°C by the heating hood, the sample was stretched at a tensile rate of 5 mm/minute to obtain a measured value of stress-strain correlation. Loads at two points where the strain was 0.2% and 0.45% were determined to obtain Young's modulus. The measurement is repeated five times on an identical sample and an average value thereof was adopted.

### [Measurement of Shear Modulus (80°C) of Elastic Layer]

After the elastic layers described in Examples and Comparative Examples were prepared in a thickness of 1.5 mm to 2 mm, each of them was punched with a punch having a diameter of 7.9 mm to form a sample for measurement.

Measurement was performed using a viscoelastic spectrometer (trade name "ARES" manufactured by Rheometric Scientific Company) with setting a temperature to 80°C, a chuck pressure to 100 g-weight, and a shear to a frequency of 1 Hz [using a stainless steel-made 8 mm parallel plate (Model 708.0157 manufactured by T A

### Instruments Company)].

### [Measurement of Shear Modulus (23°C) of Intermediate Layer]

The urethane polymer/acrylic monomer mixture obtained in Production Example 1 was applied and cured so that the thickness after cured became 50 µm, thereby obtaining an intermediate layer. The obtained intermediate layer was punched with a punch having a diameter of 7.9 mm to form a sample for measurement.
Measurement was performed using a viscoelastic spectrometer (trade name "ARES" manufactured by Rheometric Scientific Company) with setting a temperature to 23°C, a chuck pressure to 100 g-weight, and a shear to a frequency of 1 Hz [using a stainless steel-made 8 mm parallel plate (Model 708.0157 manufactured by T A Instruments Company)].

### [Measurement of Pressure-Sensitive Adhesive Strength of Pressure-Sensitive Adhesive Layer with respect to Silicon Mirror wafer]

The laminate of the non-active energy ray-curable pressure-sensitive adhesive obtained in Production Example 2 was stuck on a polyethylene terephthalate backing material (thickness of 38 µm) using a hand roller. The resulting laminate was cut into a width of 10 mm and was stuck on a 4-inch mirror silicon wafer (trade name "CZ-N" manufactured by Shin-Etsu Handotai Co., Ltd.) using a hand roller after the release sheet was removed. The resulting laminate was stuck on a stretching jig of the peeling tester using a pressure-sensitive adhesive sheet. The stretching jig was stretched at a tensile rate of 300 mm/minute in the direction of 180° to measure strength (N/10 mm) when peeling occurred between the contractible film layer and the elastic layer.
With regard to the active energy ray-curable pressure-sensitive adhesive layer obtained in Production Example 3, the pressure-sensitive adhesive strength with respect to a 4-inch mirror silicon wafer (trade name "CZ-N" manufactured by Shin-Etsu Handotai Co., Ltd.) was measured in the same manner as mentioned above except that an ultraviolet exposure of 500 mJ/cm² was performed before the measurement.

### Production Example 1 <Production of Intermediate Layer>

Into a reaction vessel fitted with a condenser tube, a thermometer and a stirring apparatus were charged 50 parts by mass of t-butyl acrylate, 30 parts by mass of acrylic acid and 20 parts by mass of butyl acrylate as acrylic monomers, 1 part by mass of trimethylolpropane triacylate as a polyfunctional monomer, 0.1 part by mass of 1-[4-(2-hydroxyethoxy)phenyl]-2-hydroxy-2-methyl-1-propan-1-one (trade name "IRGACURE 2959" manufactured by Ciba Japan Company), 73.4 parts by mass of polyoxytetramethylene glycol (molecular weight: 650, manufactured by Mitsubishi Chemical Corporation) as a polyol, and 0.05 part by mass of dibutyltin laurate as an urethane reaction catalyst. Under stirring, 26.6 parts by mass of xylylene diisocyanate was added dropwise thereto and the whole was reacted at 65°C for 2 hours to obtain a urethane polymer/acrylic monomer mixture. The amount of the polyisocyanate component and the polyol component used was as follows: NCO/OH (equivalent ratio) = 1.25.

Production Example 2 <Production of Non-Active Energy Ray-Curable Pressure-Sensitive Adhesive Layer]
With 100 parts by mass of an acrylic copolymer [obtained by copolymerization of butyl acrylate/acrylic acid = 100/3 (mass ratio)] were mixed 0.7 part by mass of trade name "TETRAD C" (manufactured by Mitsubishi Gas Chemical Co., Inc.) and 2 parts by mass of a crosslinking agent (trade name "Colonate L" manufactured by Nippon Polyurethane Industry Co., Ltd.) to prepare a non-active energy ray-curable pressure-sensitive adhesive.
The obtained non-active energy ray-curable pressure-sensitive adhesive was coated on a separator (trade name "MRF38", manufactured by Mitsubishi Polyester Film Corporation) using an applicator, and volatiles such as solvent were dried to obtain a pressure-sensitive adhesive layer/separator laminate 1 [pressure-sensitive adhesive strength (180° peeling, vs. silicon mirror wafer, tensile rate of 300 mm/minute): 0.6 N/10 mm] in which a 30 µm-thick non-active energy ray-curable pressure-sensitive adhesive layer is provided on the separator.

### Production Example 3 <Production of Active Energy Ray-Curable Pressure-Sensitive Adhesive Layer]

An acrylic polymer having a methacrylate group in the side chain was produced by bonding 80% of the hydroxyl group of an acrylic polymer [obtained by copolymerization of butyl acrylate/ethyl acrylate/2-hydroxyethyl acrylate = 50/50/20 (mass ratio)], which is derived from 2-hydroxyethyl acrylate, to methacryloyloxyethyl isocyanate (2-isocyanatoethyl methacrylate). Based on 100 parts by mass of the acrylic polymer having a methacryalte group in the side chain, 50 parts by mass of trade name "SHIKO UV1700" (manufactured by Nippon Synthetic Chemical Industry Co., Ltd.) as a compound containing two or more functional groups having a carbon-carbon double bond, 3 parts by mass of an active energy ray polymerization initiator (trade name "IRGACURE 184", manufactured by Ciba Japan Company) and 1.5 parts by mass of a crosslinking agent (trade name "Coronate L", manufactured by Nippon Polyurethane Industry Co., Ltd.) were mixed to prepare an active energy ray-curable pressure-sensitive adhesive.
The obtained energy ray-curable pressure-sensitive adhesive was coated on a separator (trade name "MRF38", manufactured by Mitsubishi Polyester Film Corp.) using an applicator, and volatiles such as solvent were dried to obtain a pressure-sensitive adhesive layer/separator laminate 2 [pressure-sensitive adhesive strength (180° peeling, with respect to silicon mirror wafer, tensile rate of 300 mm/minute): 0.01 N/10 mm or less (after UV irradiation)] in which a 30 µm-thick active energy ray-curable pressure-sensitive adhesive layer is provided on the separator.

### Example 1

The urethane polymer/acrylic monomer mixture obtained in Production example 1 was coated on a polyethylene terephthalate film (trade name "Lumirror S10", manufactured by Toray Industries, Inc., thickness: 38 µm, Young's modulus (80°C) × thickness: 1.41×10⁵ N/m) to have a dry thickness of 30 µm. After a PET film (thickness: 38 µm) subjected to a release treatment was overlaid thereon to cover it, the covered PET film surface was irradiated with ultraviolet ray (illuminance: 163 mW/cm², light intensity: 2100 mJ/cm²) to effect curing to form an acryl-urethane layer (shear modulus (23°C): 1.89×10⁶ Pa), thereby obtaining a polyethylene terephthalate film/acryl-urethane laminate sheet (rigid film layer/intermediate layer).
Next, 100 parts by mass of an ester-based polymer (a polymer obtained from 100 parts by mass of trade name "PLACCEL CD220PL", manufactured by Daicel Chemical Industries, Ltd.) and 10 parts by mass of sebacic acid) and 10 parts by mass of a crosslinking agent (trade name "Coronate L", manufactured by Nippon Polyurethane Industry Co., Ltd.) were mixed to obtain an ester-based polymer mixed solution.
The ester-based polymer mixed solution was coated on the polyethylene terephthalate film side of the polyethylene terephthalate film/acryl-urethane laminate sheet to form an elastic layer (thickness of 30 µm, shear modulus (80°C): 2.88×10⁵ Pa). A heat contractible film (heat contractible backing material) (trade name "SPACECLEAN S5630", manufactured by Toyobo Co., Ltd., a uniaxially stretched polyester film, thickness: 30 µm) was superposed thereon, and they were laminated using a hand roller to obtain a four-layer sheet (contractible film layer/elastic layer/rigid film layer/intermediate layer).
The pressure-sensitive adhesive layer side of the pressure-sensitive adhesive layer/separator laminate 1 obtained in Production Example 2 was laminated on the acryl-urethane layer side of the four-layer sheet to obtain a pressure-sensitive adhesive sheet 1 having a five-layer structure (contractible film layer/elastic layer/rigid film layer/intermediate layer/pressure-sensitive adhesive layer) whose pressure-sensitive adhesive layer surface was protected with a separator.

### Example 2

An EEA resin film (manufactured by Mitsui-DuPont Chemical, trade name "AR201", thickness: 60 µm, shear modulus (23°C): 1.40×10⁵ Pa) was extrusion-laminated on a polyethylene terephthalate film (trade name "Lumirror S10", manufactured by Toray Industries, Inc., thickness: 38 µm, Young's modulus (80°C) × thickness: 1.41×10⁵ N/m) to obtain a polyethylene terephthalate film/EEA laminate sheet (rigid film layer/intermediate layer).
A pressure-sensitive adhesive sheet 2 having a five-layer structure was obtained in the same manner as in Example 1 except that the obtained polyethylene terephthalate film/EEA laminate sheet was used instead of the polyethylene terephthalate film/acryl-urethane laminate sheet.

### Example 3

A pressure-sensitive adhesive sheet 3 having a five-layer structure was obtained in the same manner as in Example 1 except that an acrylic polymer solution obtained by dissolving 100 parts by mass of an acrylic polymer (trade name "Rheocoat R1020S", manufactured by Dai-ichi Lace Company), 10 parts by mass of a crosslinking agent "trade name "DPHA40H" (pentaerythritol-modified acrylate, manufactured by Nippon Kayaku Co., Ltd.), 0.25 part by mass of trade name "TETRAD C" (manufactured by Mitsubishi Gas Chemical Co., Inc.), 2 parts by mass of trade name "Colonate L" (manufactured by Nippon Polyurethane Industry Co., Ltd.), and 3 parts by mass of an active energy ray polymerization initiator (trade name "IRGACURE 184", manufactured by Ciba Japan Company) in methyl ethyl ketone was used instead of the ester-based polymer mixed solution to form an elastic layer (thickness: 30 µm, shear modulus (80°C): 7.20×10⁵ Pa (after UV irradiation)).

### Example 4

A pressure-sensitive adhesive sheet 4 having a five-layer structure was obtained in the same manner as in Example 1 except that the pressure-sensitive adhesive layer/separator laminate 2 obtained in Production Example 3 was used instead of the pressure-sensitive adhesive layer/separator laminate 2 obtained in Production Example 1.

### Comparative Example 1

A pressure-sensitive adhesive sheet 5 having a four-layer structure (contractible film layer/elastic layer/rigid film layer/pressure-sensitive adhesive layer) whose pressure-sensitive adhesive layer surface was protected with a separator was obtained in the same manner as in Example 1 except that a polyethylene terephthalate film (trade name "Lumirror S10", manufactured by Toray Industries, Inc., thickness: 38 µm, Young's modulus (80°C) × thickness: 1.41×10⁵ N/m) was used instead of the polyethylene terephthalate film/acryl-urethane laminate sheet.

### Comparative Example 2

The pressure-sensitive adhesive layer side of the pressure-sensitive adhesive layer/separator laminate 1 obtained in Production Example 2 was laminated on the acryl-urethane layer side of the polyethylene terephthalate film/acryl-urethane laminate sheet obtained in Example 1 to obtain a pressure-sensitive adhesive sheet 6 having three-layer structure (rigid film layer/intermediate layer/pressure-sensitive adhesive layer) whose pressure-sensitive adhesive layer surface was protected with a separator.

Table 1 shows summary of the above Examples and Comparative Examples. In the table, "PSA" means a pressure-sensitive adhesive and "UV" means an ultraviolet ray-curable pressure-sensitive adhesive in the column of the pressure-sensitive adhesive layer. In the column of the intermediate layer, "AU" means an acryl-urethane mixed resin and "EEA" means an ethylene-ethyl acrylate copolymer. In the column of the rigid backing material, "PET" means polyethylene terephthalate. In the column of the heat contractible backing material, "TSF" means a heat contractible backing material. Moreover, "G"' means shear modulus and "E"' means Young's modulus.

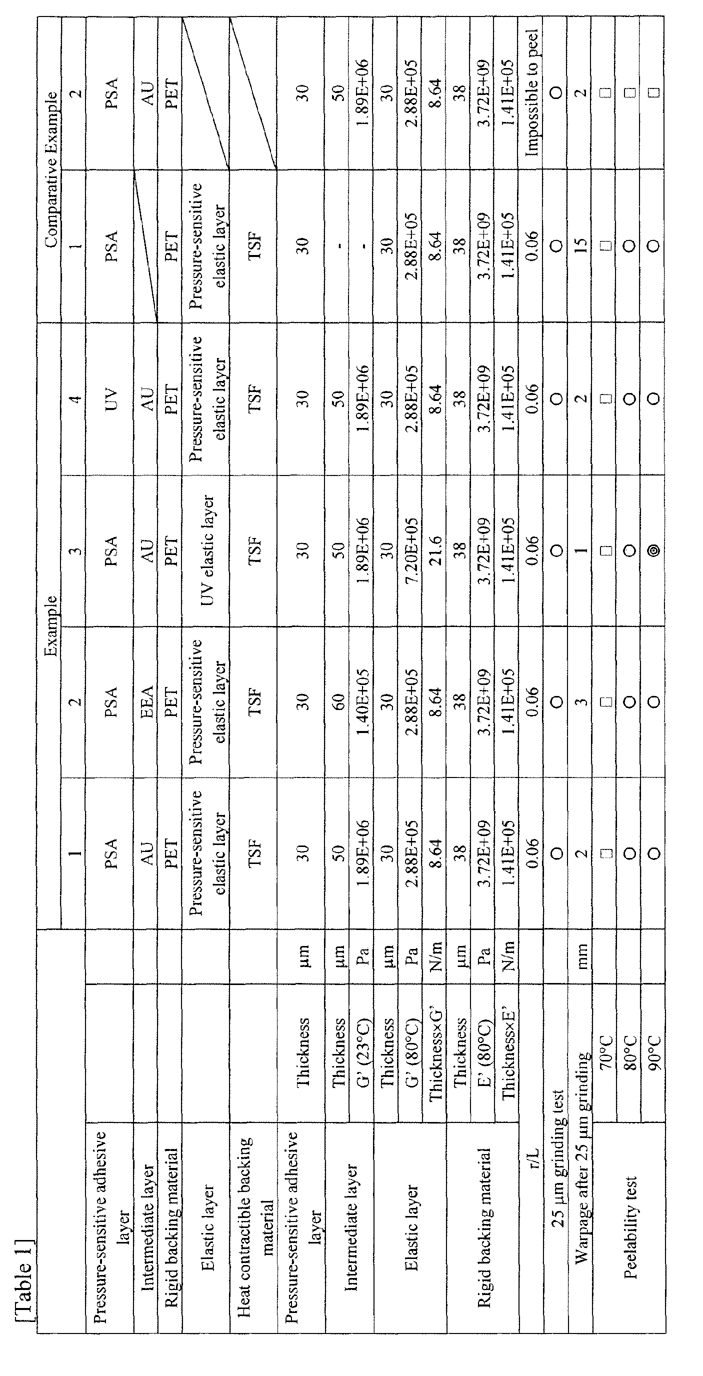

### <25 µm-thick Wafer (8 inch) Grinding Test>

Each of the pressure-sensitive adhesive sheets obtained in Examples and Comparative Examples was stuck on 8-inch mirror wafer using a tape-sticking apparatus (trade name "DR-3000II", manufactured by Nitto Seiki Company, stage temperature: 24°C) and the wafer was ground to a thickness of 25 µm using a wafer grinder (trade name "DFG8560", manufactured by Disco Corp.). After grinding, the state of the wafer was visually observed and evaluated according to the following criteria.

### Evaluation criteria:

After grinding, no cracking of the wafer is observed and the size of chipping at the end part (edge chipping) is 30 µm or less: O
After grinding, no cracking of the wafer is observed and the size of chipping at the end part (edge chipping) is 30 µm or more: Δ
After grinding, the wafer is cracked: X

### <Wafer Warpage Test>

With regard to those whose results of the above grinding test were O or Δ, a wafer in the state where the pressure-sensitive adhesive sheet had been stuck thereto was mounted on a surface plate so that the pressure-sensitive adhesive sheet was upward. Among the distances from the surface plate to the wafer, the distance (mm) of two points on the most deviated position was measured and an average value was determined.

### <Peelability Test>

Each of the pressure-sensitive adhesive sheets obtained in Examples and Comparative Examples was cut into a circular form whose size was the same as that of 4-inch silicon wafer and was stuck on 4-inch silicon wafer (thickness: 525 µm) and then the rear surface of the wafer was ground until the thickness reached 100 µm.
With regard to Example 3 where the elastic layer was composed of an active energy ray-curable pressure-sensitive adhesive and Example 4 where the pressure-sensitive adhesive layer was an active energy ray-curable pressure-sensitive adhesive layer, the elastic layer in Example 3 and the pressure-sensitive adhesive layer in Example 4 were cured by irradiation with ultraviolet ray at an intensity of 500 mJ/cm² from the pressure-sensitive adhesive sheet side.
The pressure-sensitive adhesive sheet was placed on a hot stage fitted with an adsorption chuck so that the pressure-sensitive adhesive layer came into contact with the hot stage and heated at a predetermined temperature so as to cause heat contraction of the contractible film layer constituting the pressure-sensitive adhesive sheet, the sheet being evaluated according to the following criteria.

### Evaluation criteria:

The case where the pressure-sensitive adhesive sheet undergoes rolling from one outer edge (one end part) of the sheet to the other outer edge in one direction to be a cylindrical form by heating and is rapidly peeled from the wafer without damaging the wafer (peeling with one-direction rolling): Ⓞ
The case where the pressure-sensitive adhesive sheet undergoes rolling from opposing two end parts of the sheet toward a center to form two cylindrical rolls by heating and is rapidly peeled from the wafer without damaging the wafer (peeling with two-direction rolling): O
The case where the pressure-sensitive adhesive sheet is damaged between the contractible film layer and the elastic layer or does not cleanly undergoes rolling into a cylindrical form by heating: X
The case where no change is observed even upon heating: □

### <Measurement of r/L Value>

The pressure-sensitive adhesive sheets obtained in Examples and Comparative Examples were cut into a size of 100 mmx 100 mm (L: 100 mm).
With regard to Example 3 where the elastic layer is composed of an active energy ray-curable pressure-sensitive adhesive and Example 4 where the pressure-sensitive adhesive layer is an active energy ray-curable pressure-sensitive adhesive layer, the elastic layer in Example 3 and the pressure-sensitive adhesive layer in Example 4 were cured by irradiation with ultraviolet ray at an intensity of 500 mJ/cm² from the pressure-sensitive adhesive sheet side.
Thereafter, one end part of the pressure-sensitive adhesive sheet was immersed in a hot water at 80°C along the contraction axis direction of the contractible film to promote deformation. With regard to those formed into cylindrical rolls, diameter (r: mm) was determined using a ruler and the value was divided by 100 mm to obtain a value of r/L.

The present application is based on Japanese Patent Application No. 2008-271449 filed on October 21, 2008, and the contents are incorporated herein by reference.

### Industrial Applicability

According to the pressure-sensitive adhesive sheet with spontaneously rolling property of the present invention, the warpage of an adherend generated upon grinding of the adherend can be suppressed and, after grinding, by applying a stimulus such as heating that causes contraction, the sheet undergoes spontaneous rolling from an end part (one end part or opposing two end parts) usually in the main contraction axis direction with peeling from the adherend to form a cylindrical roll, so that the sheet can be extremely easily peeled from the adherend without damaging the adherend and staining the adherend owing to imperfect peeling. Therefore, the pressure-sensitive adhesive sheet with spontaneously rolling property of the invention is useful as a pressure-sensitive adhesive sheet for re-peeling such as a pressure-sensitive adhesive sheet for wafer temporary fixing or a pressure-sensitive adhesive sheet for wafer protection which is used in a processing step of semiconductor silicon wafers and the like.

### Description of Reference Numerals and Signs

- 1: Pressure-sensitive adhesive sheet with spontaneously rolling property
- 2: Semiconductor wafer
- 11: Contractible film layer
- 12: Elastic layer
- 13: Rigid film layer
- 14: Intermediate layer
- 15: Pressure-sensitive adhesive layer

## Claims

1. A pressure-sensitive adhesive sheet with spontaneously rolling property, comprising a contractible film layer, an elastic layer, a rigid film layer, an intermediate layer, and a pressure-sensitive adhesive layer satisfying the following requirements and laminated in this order, which is capable of undergoing spontaneous rolling from one end part in one direction or from opposing two end parts toward a center to form one or two cylindrical rolls when a stimulus causing a contraction is applied:
the elastic layer having a thickness of from 15 to 150 µm and a shear modulus at 80°C of from 1×10⁴ Pa to 5×10⁶ Pa,
the intermediate layer having a shear modulus at 23°C of from 1×10⁴ Pa to 4×10⁷ Pa, and
the pressure-sensitive adhesive layer having a pressure-sensitive adhesive strength of the pressure-sensitive adhesive layer or the pressure-sensitive adhesive layer after an adhesion reducing treatment (180° peeling, vs. silicon mirror wafer, tensile rate: 300 mm/minute) of 6.5 N/10 mm or less.

2. The pressure-sensitive adhesive sheet with spontaneously rolling property according to claim 1, wherein the contractible film layer is composed of a heat contractible film of which a heat contraction ratio in the main contraction direction at a predetermined temperature in the range of 70 to 180°C is from 30 to 90%.

3. The pressure-sensitive adhesive sheet with spontaneously rolling property according to claim 1 or 2, wherein the elastic layer has a product of the shear modulus at 80°C and the thickness ranging from 1 to 1000 N/m.

4. The pressure-sensitive adhesive sheet with spontaneously rolling property according to any one of claims 1 to 3, wherein the rigid film layer has a product of a Young's modulus at 80°C and a thickness of 3×10⁵ N/m or less.

5. The pressure-sensitive adhesive sheet with spontaneously rolling property according to any one of claims 1 to 4, wherein a ratio (r/L) of the diameter r of the cylindrical roll formed by spontaneous rolling when the pressure-sensitive adhesive sheet with spontaneously rolling property is contracted by applying the stimulus that causes the contraction to said sheet relative to the length L of the pressure-sensitive adhesive sheet with spontaneously rolling property in the rolling direction ranges from 0.001 to 0.333.
